# EUROPEAN PATENT APPLICATION

(11) **EP 2 437 311 A2**
(43) Date of publication of application: **04.04.2012**
(21) Application number: 11007050.5
(22) Date of filing: 30.08.2011
(51) Int. Cl.: H01L 31/048

(54) **Solar cell module and manufacturing method thereof**

(30) Priority: 29.09.2010 KR 20100094614
(71) Applicant: LG Electronics Inc., Youngdungpo-ku Seoul 150-721 (KR)
(72) Inventor: Moon, Kangseok, Seoul 137-724 (KR)
(74) Representative: Katérle, Axel

(57) **Abstract**

Discussed herein are a solar cell module, the edge of which is efficiently sealed, and a manufacturing method thereof. The solar cell module includes a front substrate, a rear substrate disposed opposite the front substrate, solar cells disposed between the front substrate and the rear substrate, a barrier layer disposed at least one of between an outer portion of the front substrate and at least one of the solar cells, between the outer portion of the front substrate and the rear substrate, and between the at least one of the solar cells and the rear electrode, and a sealant, at least a part of which is disposed between the rear substrate and the at least one of the solar cells to the inside of the barrier layer in the solar cell module.

## Description

### BACKGROUND OF THE INVENTION

### 1. Field of the invention

Embodiments of the present invention relate to a solar cell module and a manufacturing method thereof, and more particularly to a solar cell module, the edge of which is effectively sealed, and a manufacturing method thereof.

### 2. Description of the Related Art

Recently, as conventional energy resources, such as oil or coal, are expected to be depleted, interest in new alternative energy source has risen. Among alternative energy sources, solar cells are a focus of attention as next generation devices to convert sunlight energy into electrical energy using semiconductor elements.

Solar cells are devices which convert light energy into electrical energy using a photovoltaic effect. Solar cells are classified into crystalline silicon solar cells, thin film solar cells, dye-sensitized solar cells, organic solar cells, and so on. The widely used crystalline silicon solar cells have high material costs with respect to power generation efficiency and demand complicated processes for manufacture, thus being unfavorable in stable price decisions. In order to overcome such problems, interest has risen for thin film solar cells in which silicon is deposited to a thin thickness on a surface of an inexpensive glass or plastic substrate.

### SUMMARY OF THE INVENTION

An object of the present invention is to provide a solar cell module, the edge of which is effectively sealed so as to prevent moisture and other substances from penetrating the edge, and a manufacturing method thereof.

The objects of the present invention are not limited to the above-mentioned object and other objects that have not been mentioned above will become evident to those skilled in the art from the following description.

To achieve the above and other objects, there is provided a solar cell module. According to an example embodiment, the solar cell module includes a front substrate, a rear substrate disposed opposite the front substrate, solar cells disposed between the front substrate and the rear substrate, a barrier layer disposed at least one of between an outer portion of the front substrate and at least one of the solar cells, between the outer portion of the front substrate and the rear substrate and between the at least one of the solar cells and the rear substrate, and a sealant, at least a part of which is disposed between the rear substrate and the at least one of the solar cells to the inside of the barrier layer in the solar cell module.

To achieve the above objects, there is provided a manufacturing method of a solar cell module. According to an example embodiment, the method includes disposing solar cells on a front substrate, disposing a barrier layer on at least one of an outer portion of the front substrate and at least one of the solar cells, disposing at least a part of a sealant on the at least one of the solar cells to the inside of the barrier layer in the solar cell module, and stacking a rear substrate on the sealant.

The details of other embodiments may be included in the detailed description and the drawings.

According to one aspect of the invention, a solar cell module is provided which comprises a front substrate, a rear substrate disposed opposite the front substrate, and solar cells disposed between the front substrate and the rear substrate. The solar cell module further comprises a barrier layer which can be disposed at at least one of the following positions: between an outer portion of the front substrate and at least one of the solar cells, between the outer portion of the front substrate and the rear substrate, between the at least one of the solar cells and the rear substrate. The solar cell module further comprises a sealant, at least a part of which is disposed between the rear substrate and the at least one of the solar cells to the inside of the barrier layer in the solar cell module.

The solar cell module may be further configured such that the light transmittance of the sealant may differ from that of the barrier layer.

The solar cell module may be further configured such that an adhesive force between the barrier layer and either the front substrate or the rear substrate may differ from an adhesive force between the sealant and the at least of the solar cells.

The solar cell module may further include a photoelectric conversion layer configured to generate current from light, a transparent electrode layer deposited on the front substrate such that the current generated by the photo electric conversion layer flows along the transparent electrode layer, and a rear electrode layer deposited on the photoelectric conversion layer such that the current generated by the photoelectric conversion layer flows along the rear electrode layer.

The solar cell module may be further configured such that the barrier layer is disposed on the rear electrode layer of the outermost cells of the solar cells.

The solar cell module may be further configured such that the barrier layer is disposed on the outermost cells of the solar cells such that a width of the barrier layer is greater than a thickness of the barrier layer.

The solar cell module may be further configured such that the sealant is disposed on at least one of the solar cells such that the sealant is separated from the barrier layer.

The solar cell module may be further configured such that a part of the sealant is stacked on the barrier layer.

The solar cell module may be further configured such that a part of the barrier layer is stacked on the sealant.

The solar cell module may be further configured such that a part of the barrier layer is adhered to a side surface of the front substrate and/or a side surface of the rear substrate, when the front substrate, the barrier layer, and the rear substrate are laminated.

The solar cell module may further comprise a desiccant disposed between the barrier layer and the sealant. Such a solar cell module may further comprise a gap disposed between the barrier layer and the sealant, wherein the desiccant disposed between the barrier layer and the sealant is within the gap.

According to another aspect of the present invention, a manufacturing method of a solar cell module is provided. The manufacturing method comprises disposing solar cells on a front substrate, disposing a barrier layer on at least one of an outer portion of the front substrate and at least one of the solar cells, disposing at least a part of a sealant on the at least one of the solar cells to the inside of the barrier layer in the solar cell module and stacking a rear substrate on the sealant.

The disposing of the barrier layer may form the barrier layer on an outermost solar cell of the solar cell module.

### BRIEF DESCRIPTION OF THE DRAWINGS

The above and other objects, features and other advantages of one or more embodiments of the present invention will be more clearly understood from the following detailed description taken in conjunction with the accompanying drawings, in which:

FIG. 1 is a partial cross-sectional view of a solar cell module in accordance with one embodiment of the present invention;

FIG. 2 is a partial cross-sectional view of a portion 'A' of the solar cell module shown in FIG. 1;

FIG. 3 is a partial perspective view of the solar cell module shown in FIG. 1;

FIG. 4 is a flow chart illustrating a manufacturing method of a solar cell module in accordance with one embodiment of the present invention;

FIG. 5 is a partial cross-sectional view of a solar cell module in accordance with another embodiment of the present invention;

FIG. 6 is a partial cross-sectional view of a solar cell module in accordance with another embodiment of the present invention;

FIG. 7 is a partial cross-sectional view of a solar cell module in accordance with another embodiment of the present invention; and

FIG. 8 is a partial cross-sectional view of a solar cell module in accordance with another embodiment of the present invention.

### DETAILED DESCRIPTION OF THE EMBODIMENTS

Reference will now be made in detail to example embodiments of the present invention, examples of which are illustrated in the accompanying drawings. Wherever possible, the same reference numbers will be used throughout the drawings to refer to the same or like parts.

Hereinafter, the embodiments of the present invention will be described with reference to the accompanying drawings.

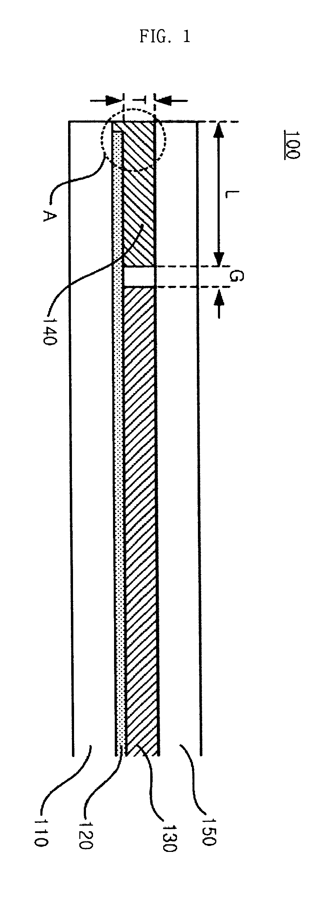

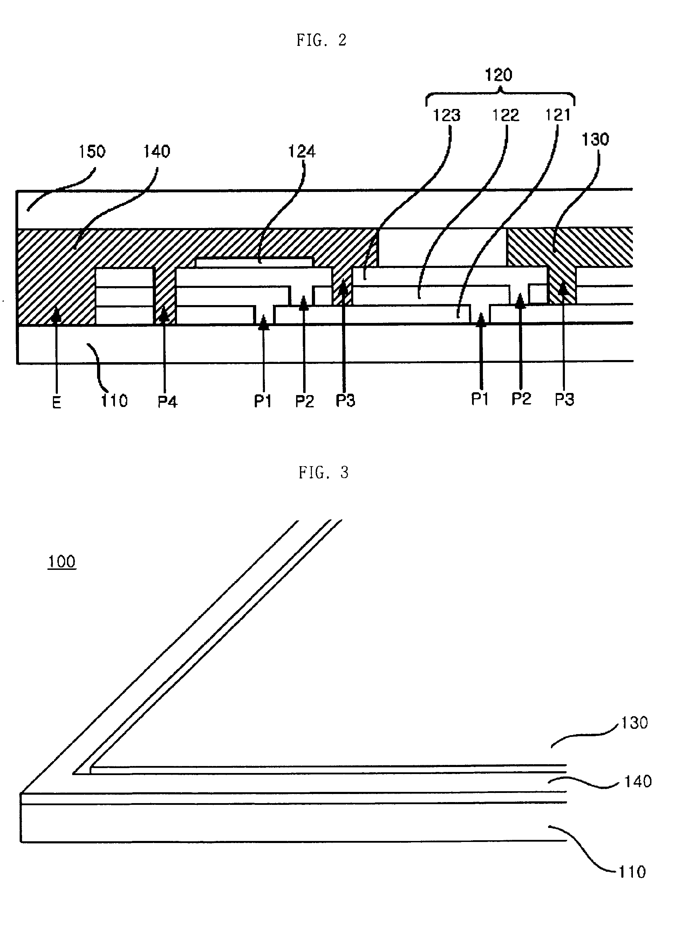

FIG. 1 is a partial cross-sectional view of a solar cell module in accordance with one embodiment of the present invention, FIG. 2 is a partial cross-sectional view of a portion 'A' of the solar cell module shown in FIG. 1, and FIG. 3 is a partial perspective view of the solar cell module shown in FIG. 1.

A solar cell module 100 in accordance with this embodiment of the present invention includes a front substrate 110, a rear substrate 150 positioned opposite the front substrate 110, solar cells 120 disposed between the front substrate 110 and the rear substrate 150, a barrier layer 140 disposed between the rear substrate 150 and at least one of an outer portion of the front substrate 110 and the solar cells 120, and a sealant 130, at least a part of which is disposed between the rear substrate 150 and the solar cells 120 to the inside of the barrier layer 140 in the solar cell module 100. In one or more embodiments of the present invention, reference to an outer portion of the front substrate 110 refers to an outer peripheral portion of the front substrate 110.

The front substrate 110 may be made of a transparent material, such as glass, so as to transmit light, such as sunlight, and is preferably, but not necessarily, made of tempered glass so as to protect the solar cells 120 from an external impact. Further, the front substrate 110 is preferably, but not necessarily, made of tempered glass having a low iron content so as to reduce or prevent reflection of the light and to increase transmittance of the light.

The front substrate 110 has a light receiving surface, upon which the light is incident, and a rear surface opposite the light receiving surface. The solar cells 120 are disposed between the front substrate 110 and the rear substrate 150. The solar cells 120 generate photoelectro-motive force (or current or electricity) from light having passed through the front substrate 110. With reference to FIG. 2, the solar cells 120 include a transparent electrode layer 121 deposited on a rear surface of the front substrate 110, and a photoelectric conversion layer 122 deposited on the transparent electrode layer 121 to generate photoelectro-motive force (or current or electricity) from light.

The transparent electrode layer 121 serves as a channel along which current generated by the photoelectric conversion layer 122 flows. The transparent electrode layer 121 may be formed by doping zinc oxide (ZnO) with at least one selected from aluminum (Al), gallium (Ga), fluorine (F), germanium (Ge), magnesium (Mg), boron (B), indium (In), tin (Sn) and lithium (Li). In this embodiment, the transparent electrode layer 121 may be made of a conductive oxide, such as ZnO:Al or SnO:Al, or may have a stacked structure of ZnO:Al and SnO:Al.

A certain impurity serving as a dopant improves electrical characteristics of zinc oxide (ZnO), and zinc oxide (ZnO) doped with the impurity is advantageous in that it is easily etched as compared with indium tin oxide (ITO), is non-toxic and can be grown at a low temperature. Such doping of zinc oxide (ZnO) with the impurity may include doping of zinc oxide (ZnO) with a metal using a doping method, such as chemical doping, electrochemical doping or ion implantation, but is not limited thereto.

The surface of the transparent electrode layer 121 may have an uneven structure so as to increase paths (or path lengths) of incident light to allow the photoelectric conversion layer 122 to absorb a large or larger amount of light. Since P-N junctions are formed on the photoelectric conversion layer 122, when the light is irradiated onto the photoelectric conversion layer 122, the photoelectric conversion layer 122 generates photoelectro-motive force (or current or electricity) using a photoelectric conversion effect. The photoelectric conversion layer 122 may be made of a semiconductor having a particular characteristic, such as amorphous silicon (a-Si), microcrystalline silicon µc-Si) or a compound semiconductor, or be formed in a tandem type arrangement, but is not limited thereto.

A rear electrode layer 123 is deposited on the photoelectric conversion layer 122, and serves as a channel along which current generated by the photoelectric conversion layer 122 flows, together with the transparent electrode layer 121. The rear electrode layer 123 may be made of a transparent, a translucent material or an opaque metal, such as silver (Ag) or aluminum (Al). Further, the rear electrode layer 123 may be made of a conductive oxide, such as ZnO:Al or SnO:Al, or may have a stacked structure of ZnO:Al and SnO:Al, in the same manner as the transparent electrode layer 121.

A first scribing P1 is carried out after deposition of the transparent electrode layer 121 on the rear surface of the front substrate 110, a second scribing P2 is carried out after deposition of the photoelectric conversion layer 121 on the transparent electrode layer 121, and a third scribing P3 is carried out after deposition of the rear electrode layer 123 on the photoelectric conversion layer 122, thereby forming the solar cells 120 divided from each other. Then, the solar cells 120 are connected in series. Further, the solar cells 120 are electrically insulated from each other through a fourth scribing P4 and an edge deletion E after the third scribing P3.

A bus bar 124 is preferably disposed on upper surfaces of outermost cells formed at outermost regions of the solar cells 120. The outermost cells of the solar cells 120 are formed between the third scribing P3 and the fourth scribing P4. The bus bar 124 is preferably disposed on an upper surface of the rear electrode layer 123 disposed at the outermost region of the solar cells 120. That is, the bus bar 124 is formed on the upper surface of the rear electrode 123 of the outermost cell disposed at the outermost region of the solar cells 120. According to embodiments, the bus bar 124 may be disposed on the upper surface of the transparent electrode layer 121 of the outermost cell. The bus bars 124 is further disposed on upper surfaces of the transparent electrode layers 121 of the outermost cells.

The bus bar 124 is adhered to the outermost cells of the solar cells 120 using a conductive paste made of silver (Ag) or a conductive film in which multiple conductive particles, such as nickel (Ni), are distributed into a synthetic resin, such as epoxy, or through spot soldering. According to embodiments, the bus bar 124 may be formed on the upper surfaces of the outermost cells of the solar cells 120 by a direct printing method.

The barrier layer 140 may be disposed on at least one of an outer portion of the rear surface of the front substrate 110 and the outermost cells of the solar cells 120. The barrier layer 140 is preferably disposed on the outer portion of the rear surface of the front substrate 110 and the outermost cells of the solar cells 120. Further, the barrier layer 140 may be disposed on the outer portion of the rear surface of the front substrate 110 and the outermost cells and cells adjacent thereto of the solar cells 120. The barrier layer 140 may be disposed only on the outer portion of the rear surface of the front substrate 110 where a width is secured through edge deletion E.

With reference to FIG. 2, the barrier layer 140 may be disposed on at least one of the outer portion of the rear surface of the front substrate 110, a surface of the rear electrode layer 123 of the outermost cells, a surface of the transparent electrode layer 121, and a surface of the bus bar 124. According to embodiments of the present invention, the barrier layer 140 may also be disposed on a surface of the rear electrode layer 123 of the cells adjacent to the outermost cells. That is, the barrier layer 140 may be disposed on the cells that are located to the inside of the outermost cells in the solar cell module 100.

If the barrier layer 140 is disposed on the outer portion of the rear surface of the front substrate 110 that are exposed through the fourth scribing P4 and the edge deletion E, as shown in FIG. 2, the barrier layer 140 prevents moisture penetration and increases an insulation effect on the edge of the front substrate 110. The barrier layer 140 may be made of at least one of polybutylene-based materials, polyethylene-based materials and polyvinyl-based materials having an excellent moistureproof function to block moisture, and is preferably, but not necessarily, made of polyisobutylene, butyl rubber, silicon or silicone. Further, the barrier layer 140 may be applied in a softened state, or the barrier layer 140 of a tape type may be arranged or applied.

The barrier layer 140 is preferably formed on the outer solar cells 120 such that a width L of the barrier layer 140 is greater than a thickness T of the barrier layer 140, thereby boosting or ensuring moistureproof performance thereof.

The sealant 130 is disposed on the solar cells 120 to the inside of the barrier layer 140 in the solar cell module 100. With reference to FIG. 2, the sealant 130 may be disposed on at least one of a surface of the bus bar 124, a surface of the transparent electrode layer 121 and a surface of the rear electrode layer 123. The sealant 130 may be disposed on the surface of the bus bar 124 and an outer portion of the rear surface of the front substrate 110 as well as on the surface of the transparent electrode layer 121 and the surface of the rear electrode layers 123 of the outermost cells, according to a width of the barrier layer 140.

At least a portion of the sealant 130 to the inside of the barrier layer 140 in the solar cell module 100, and the sealant 130 may be separated from the barrier layer 140 or be partially overlapped with the barrier layer 140 according to one or more embodiments.

In this embodiment, the sealant 130 is preferably disposed to be separated from the barrier layer 140. This serves to assure a clearance into which the barrier layer 140 and/or the sealant 130 is/are spread out when heating and pressing are performed while carrying out lamination after stacking the rear substrate 150 on the front substrate 110. After the lamination, the sealant 130 and the barrier layer 140 are preferably adhered to each other.

The sealant 130 is preferably disposed to be separated from the barrier layer 140 by a distance that is equal to or less than a thickness of the barrier layer 140. A separation distance G between the sealant 130 and the barrier layer 140 is preferably, but not necessarily, greater than 0.05mm and less than 1mm.

The sealant 130 preferably, but not necessarily, has a thickness similar to that of the barrier layer 140, thereby preventing the barrier layer 140 from being separated from the front substrate 110 or the rear substrate 150 after the lamination. The sealant 130 is preferably disposed after disposition of the barrier layer 140. However, according to embodiments, the sealant 130 may be disposed first and then the barrier layer 140 may be disposed to the outside of the sealant 130 in the solar cell module 100.

The sealant 130 serves to block external moisture or oxygen and to adhere the rear substrate 150 to the solar cells 120. The sealant 130 may be made of ethylene vinyl acetate (EVA), polyvinyl butyral (PVB), ethylene vinyl acetate (EVA) partial oxide, silicon resin, ester-based resin or olefin-based resin. The sealant 130 may be applied in a softened state, or the sealant 130 of a tape type may be arranged or applied.

The sealant 130 is preferably, but not necessarily, made of a transparent material. The barrier layer 140 is disposed on at least one of the outer portion of the rear surface of the front substrate 110 and the outermost cells of the solar cells 120, and thus, does not need to be made of a transparent material, but the sealant 130 is disposed on most of the solar cells 120 and is thus preferably, but not necessarily, made of a transparent material. That is, light transmittance of the sealant 130 differs from light transmittance of the barrier layer 140. Preferably, but not necessarily, light transmittance of the sealant 130 is higher than light transmittance of the barrier layer 140.

Peel strength of the barrier layer 140 with respect to the front substrate 110 or the rear substrate 150, which is made of tempered glass, is greater than 10 kgf/cm. On the other hand, peel strength of the barrier layer 140 with respect to the photoelectric conversion layer 122, the rear electrode layer 123 or the bus bar 124 of the solar cells 120 is 0.5~5 kgf/cm.

That is, an adhesive force between the barrier layer 140 and the front substrate 110 or the barrier layer 140 and the rear substrate 150 differs from an adhesive force between the sealant 130 and the solar cells 120. Substantially, the adhesive force between the barrier layer 140 and the front substrate 110 or the barrier layer 140 and the rear substrate 150 is greater than the adhesive force between the sealant 130 and the solar cells 120. Therefore, the barrier layer 140 is preferably disposed on the outer rear surface of the front substrate 110 and adhered to the rear substrate 150, to thereby preventing penetration of external moisture and air into the solar cells 120. Further, the sealant 130 is preferably adhered to the barrier layer 140 having a high adhesive force after the lamination.

The rear substrate 150 is disposed opposite the front substrate 110 such that the solar cells 120 are interposed between the front substrate 110 and the rear substrate 150. The rear substrate 150 is stacked on the sealant 130, and in this embodiment, the outer portion of the rear substrate 150 is stacked on the barrier layer 140.

The rear substrate 150 has waterproof, insulating and UV shielding functions. The rear substrate 150 may be formed as a Tedlar/PET/Tedlar (TPT) type, but is not limited thereto. Further, the rear substrate 150 may be made of a material having high reflectance so as to reflect the light incident from the front substrate 110 to reuse the light, or be made of a transparent material so as to allow the light to be incident upon the rear substrate 150. In this embodiment, the rear substrate 150 is made of tempered glass in the same manner as the front substrate 110.

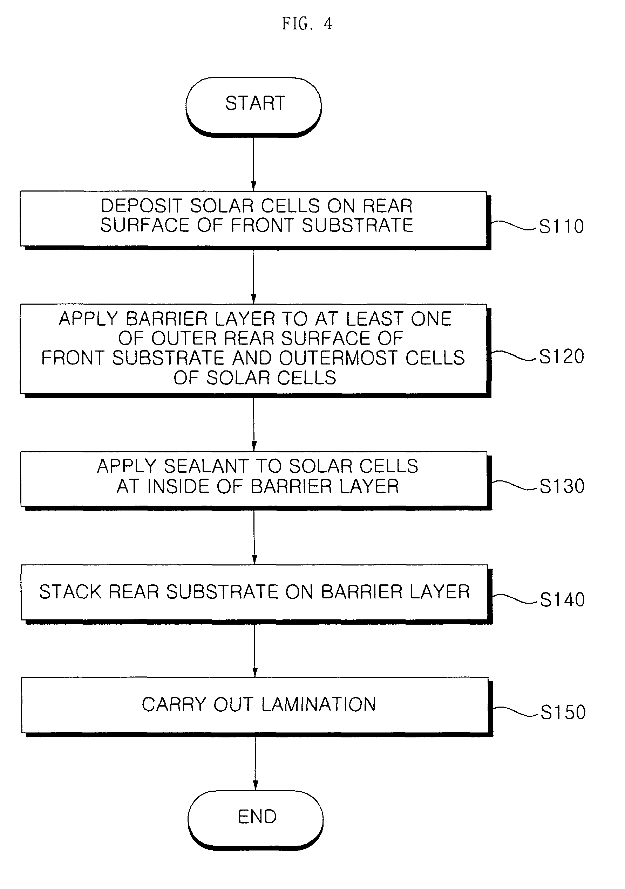

FIG. 4 is a flow chart illustrating a manufacturing method of a solar cell module in accordance with one embodiment of the present invention. The solar cells 120 are deposited on the rear surface of the front substrate 110 (Operation S110). The solar cells 120 may be deposited on the front substrate 110 through various methods, and is preferably, but not necessarily, manufactured in a structure in which the solar cells 120 deposited on the front substrate 110 are divided from each other by scribing and is then connected in series.

Preferably, the first scribing P1 is carried out after deposition of the transparent electrode layer 121 on the rear surface of the front substrate 110, the second scribing P2 is carried out after deposition of the photoelectric conversion layer 121 on the transparent electrode layer 121, and the third scribing P3 is carried out after deposition of the rear electrode layer 123 on the photoelectric conversion layer 122. Further, the solar cells 120 are electrically insulated from each other through the fourth scribing P4 and the edge deletion E after the third scribing P3.

Thereafter, the barrier layer 140 is applied to at least one of the outer portion of the rear surface of the front substrate 110 and the outermost cells of the solar cells 120 (Operation S120). The barrier layer 140 is preferably disposed on at least one of the outer portion of the rear surface of the front substrate 110 and the outermost cells of the solar cells 120, and may be disposed only on the outer portion of the rear surface of the front substrate 110 where a width is secured through the edge deletion E. Further, the barrier layer 140 may be disposed on the outermost cells and cells adjacent thereto of the solar cells 120 according to embodiments.

The barrier layer 140 may be applied in a softened state, or the barrier layer 140 of a tape type may be arranged or applied. In this embodiment, the barrier layer 140 is applied in the softened state.

The barrier layer 140 is preferably formed on the outer solar cells 120 such that a width L of the barrier layer 140 is greater than a thickness T of the barrier layer 140, thereby boosting or ensuring moistureproof performance thereof. The barrier layer 140 may be disposed on the rear electrode layer 123 and the transparent electrode layer 121 of the outermost cells of the solar cells.

Thereafter, the sealant 130 is applied to the solar cells 12 to the inside of the barrier layer 140 in the solar cell module 100 (Operation S130). The sealant 130 is preferably disposed to be separated from the barrier layer 140. The sealant 130 is preferably disposed to be separated from the barrier layer 140 by a distance that is equal to or less than the thickness of the barrier layer 140. The separation distance G between the sealant 130 and the barrier layer 140 is preferably, but not necessarily, greater than 0.05mm and less than 1mm.

The sealant 130 may be applied in a softened state, or the sealant 130 of a tape type may be arranged or applied. In this embodiment, the sealant 130 is applied in the softened state.

Although this embodiment illustrates that the sealant 130 is disposed after disposition of the barrier layer 140, the sealant 130 may be disposed first and then the barrier layer 140 may be disposed to the outside of the sealant 130 in the solar cell module 100 according to embodiments.

Thereafter, the rear substrate 150 is stacked on the barrier layer 140 (Operation S140). In this embodiment, the outer rear substrate 150 is stacked on the barrier layer 140 and the inner region of the rear substrate 150 positioned to the inside of the barrier layer 140 in the solar cell module 100 is stacked on the sealant 130.

Thereafter, lamination is carried out (Operation S150). When the rear substrate 150 is heated and pressed, the rear substrate 150 is adhered to the solar cells 120 by the sealant 130, thereby completing the solar cell module 100.

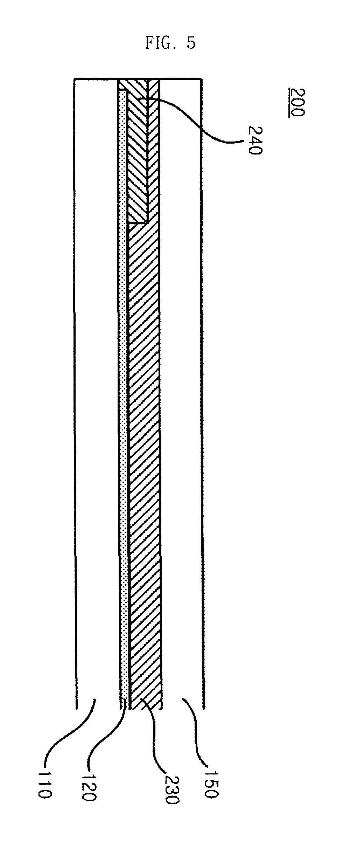

FIG. 5 is a partial cross-sectional view of a solar cell module in accordance with another embodiment of the present invention. In a solar cell module 200 in accordance with this embodiment of the present invention, a sealant 230 is disposed on the barrier layer 240 to be stacked on the upper surface of the barrier layer 240 as well as on a region of the solar cells 120 to the inside of the barrier layer 240 in the solar cell module 200.

In order to prevent the barrier layer 240 from being separated from the front substrate 110 or the rear substrate 150 after lamination due to a thickness difference between the barrier layer 240 and the sealant 230 or a shrinkage difference between the barrier layer 240 and the sealant 230 after the lamination, the sealant 230 is disposed on the barrier layer 240. An adhesive force between the sealant 230 and the barrier layer 240 is greater than an adhesive force between the sealant 230 and the solar cells 120. The sealant 230 disposed on the barrier layer 240 serves to adhere the barrier layer 240 to the rear substrate 150, thereby preventing the barrier layer 240 from being separated from the rear substrate 150.

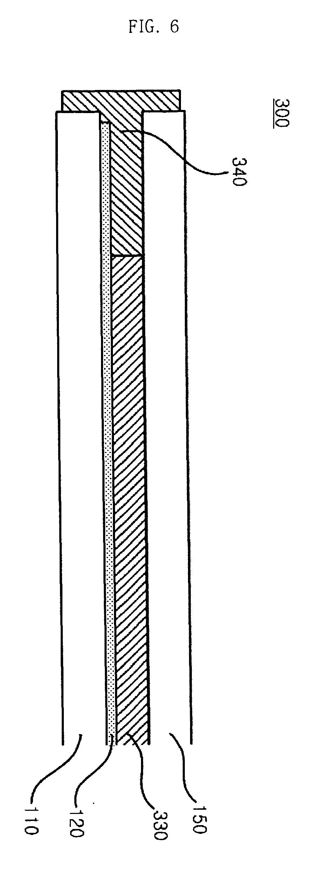

FIG. 6 is a partial cross-sectional view of a solar cell module in accordance with another embodiment of the present invention. In a solar cell module 300 in accordance with this embodiment of the present invention, a part of a barrier layer 340 is adhered to side surface(s) (e.g., lateral surface(s)) of the front substrate 110 and/or the rear substrate 150 after lamination. The barrier layer 340 is made of a material which can be melted during the lamination, and is adhered to the side surface(s) of the front substrate 110 and/or the rear substrate 150 through heating and pressing. The barrier layer 340 is adhered to the side surface(s) of the front substrate 110 and/or the rear substrate 150, thereby preventing penetration of moisture into a space between the front substrate 110 and the rear substrate 150 and thus improving moistureproof performance. Additionally, a sealant 330 is disposed on the solar cells 120.

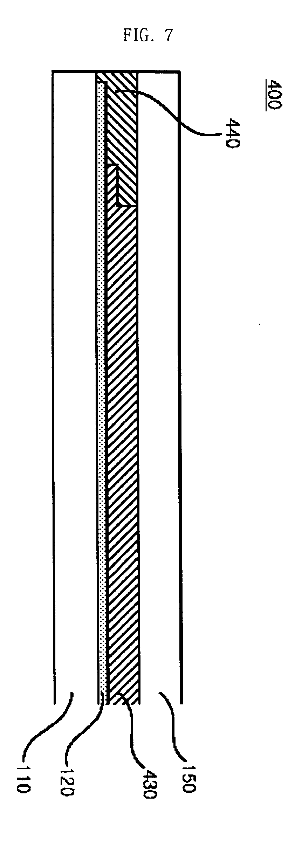

FIG. 7 is a partial cross-sectional view of a solar cell module in accordance with another embodiment of the present invention. In a solar cell module 400 in accordance with this embodiment of the present invention, a sealant 430 is disposed first on the solar cells 120 and then a barrier layer 440 is disposed to the outside of the sealant 430 in the solar cell module 400. In this instance, a part of the barrier layer 440 may be disposed to be stacked on the sealant 430. Alternatively, the barrier layer 440 may be disposed first on the front substrate 110, and then a portion of the sealant 430 may be formed over the barrier layer 440.

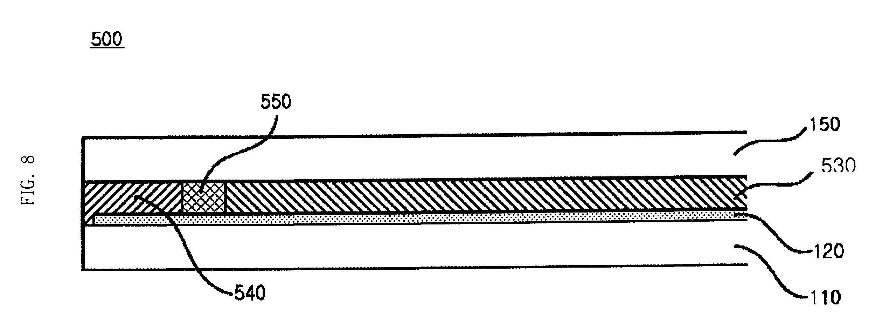

FIG. 8 is a partial cross-sectional view of a solar cell module in accordance with a further embodiment of the present invention. A solar cell module 500 in accordance with this embodiment of the present invention further includes, for example, a desiccant 550 disposed between a barrier layer 540 and a sealant 530. The desiccant 550 is made of a material including, for example, a weak alkaline component, such as calcium chloride or calcium carbonate, or a strong alkaline component, such as sodium hydroxide or potassium hydroxide. Further, an adhesive agent may be mixed with such a material according to one or more embodiments.

The desiccant 550 is disposed between the barrier layer 540 and the sealant 530 on the rear surface of the front substrate 110 or on the solar cells 120, and absorbs moisture penetrated into the barrier layer 540, thereby protecting the solar cells 120.

As apparent from the above description, the present invention provides a solar cell module and a manufacturing method thereof having one or more effects below.

First, a space between an outer portion of a front substrate and an outer portion of a rear substrate is effectively sealed.

Second, penetration of moisture into the space between the outer portion of the front substrate and the outer portion of the rear substrate is prevented, thereby increasing moistureproof performance of the solar cell module.

Third, the space between the outer portion of the front substrate and the outer portion of the rear substrate is sealed through a simple and convenient process.

Fourth, an insulating effect upon an edge of the solar cell module is raised.

The effects of the one or more embodiments of the present invention are not limited to the above-mentioned effects, and other effects that have not been mentioned above will become evident to those skilled in the art from the accompanying claims.

Although the embodiments of the present invention have been disclosed for illustrative purposes, those skilled in the art will appreciate that various modifications and applications are possible, without departing from the scope of the invention as disclosed in the accompanying claims. For example, the respective elements described in detail in the embodiments may be modified. Further, it will be understood that differences relating to such modifications and applications are within the scope of the invention defined in the accompanying claims.

## Claims

1. A solar cell module (100) comprising:
a front substrate (110);
a rear substrate (150) disposed opposite the front substrate (110);
solar cells (120) disposed between the front substrate (110) and the rear substrate (150);
a barrier layer (140) disposed at least one of between an outer portion of the front substrate (110) and at least one of the solar cells (120), between an outer portion of the front substrate (110) and the rear substrate (150), and between the at least one of the solar cells (120) and the rear substrate (150); and
a sealant (130), at least a part of which is disposed between the rear substrate (150) and the at least one of the solar cells (120) to the inside of the barrier layer (140) in the solar cell module (100).

2. The solar cell module (100) according to claim 1, wherein light transmittance of the sealant (130) differs from light transmittance of the barrier layer (140).

3. The solar cell module (100) according to claim 1 or 2, wherein an adhesive force between the barrier layer (140) and the front substrate (110) or the rear substrate (150) differs from an adhesive force between the sealant (130) and the at least one of the solar cells (120).

4. The solar cell module (100) according to any one preceding claim, wherein each solar cell (120) includes:
a photoelectric conversion layer (122) configured to generate current from light;
a transparent electrode layer (121) deposited on the front substrate (110) such that the current generated by the photoelectric conversion layer (122) flows along the transparent electrode layer (121); and
a rear electrode layer (123) deposited on the photoelectric conversion layer (122) such that the current generated by the photoelectric conversion layer (122) flows along the rear electrode layer (123).

5. The solar cell module (100) according to claim 4, wherein the barrier layer (140) is disposed on the rear electrode layer of outermost cells of the solar cells.

6. The solar cell module (100) according to any one preceding claim, wherein the barrier layer (140) is disposed on outermost cells of the solar cells (120) such that a width of the barrier layer is greater than a thickness of the barrier layer.

7. The solar cell module according to any one preceding claim, wherein the sealant is disposed on at least one of the solar cells such that the sealant is separated from the barrier layer.

8. The solar cell module according to any one preceding claim, wherein a part of the sealant (230) is stacked on the barrier layer (240).

9. The solar cell module according to any one preceding claim, wherein a part of the barrier layer (440) is stacked on the sealant (420).

10. The solar cell module according to any one preceding claim, wherein a part of the barrier layer (340) is adhered to a side surface of the front substrate (110) and/or a side surface of the rear substrate (150) when the front substrate, the barrier layer (340) and the rear substrate are laminated.

11. The solar cell module according to claim 1, further comprising a desiccant (550) disposed between the barrier layer (540) and the sealant (530).

12. The solar cell module according to claim 11, further comprising a gap disposed between the barrier layer and the sealant, wherein the desiccant disposed between the barrier layer and the sealant is within the gap.

13. A manufacturing method of a solar cell module (100), the manufacturing method comprising:
disposing solar cells (120) on a front substrate (110);
disposing a barrier layer (140) on at least one of an outer portion of the front substrate (110) and at least one of the solar cells (120);
disposing at least a part of a sealant (130) on the at least one of the solar cells (120) to the inside of the barrier layer (140) in the solar cell module (100); and stacking a rear substrate (150) on the sealant (130).

14. The manufacturing method according to claim 13, wherein the disposing of the barrier layer (140) forms the barrier layer (140) on an outermost solar cell of the solar cell module (100).
